Europäisches Patentamt

European Patent Office

Office européen des brevets

(19)

(11) Veröffentlichungsnummer: **0 214 508 B1**

(12) **EUROPÄISCHE PATENTSCHRIFT**

(45) Veröffentlichungstag der Patentschrift: **25.09.91**

(51) Int. Cl.⁵: **G11C 29/00**

(21) Anmeldenummer: **86111403.1**

(22) Anmeldetag: **18.08.86**

(54) **Integrierter Halbleiterspeicher.**

(30) Priorität: **11.09.85 DE 3532443**

(43) Veröffentlichungstag der Anmeldung:
**18.03.87 Patentblatt 87/12**

(45) Bekanntmachung des Hinweises auf die
Patenterteilung:
**25.09.91 Patentblatt 91/39**

(84) Benannte Vertragsstaaten:
**AT DE FR GB IT NL**

(56) Entgegenhaltungen:
**EP-A- 0 127 015**

**IEEE INTERNATIONAL SOLID STATE CIR-
CUITS CONFERENCE, DIGEST OF TECHNICAL
PAPERS, 15. Februar 1985, Seiten
240-241,352, Coral Gables, FL; M. KUMANOYA
et al.: "A 90NS 1Mb DRAM with multi-bit test
mode"**

**IBM TECHNICAL DISCLOSURE BULLETIN,
Band 22, Nr. 10, März 1980, Seiten 4564-4565,
New York, US; R.C. VARSHNEY: "CCD memory with testing capability"**

**PATENT ABSTRACTS OF JAPAN, Band 7, Nr.
270 (P-240)[1415], 2. Dezember 1983; & JP-**

A-58 150 198

(73) Patentinhaber: **Siemens Aktiengesellschaft
Wittelsbacherplatz 2
W-8000 München 2(DE)**

(72) Erfinder: **Fuchs, Hans Peter, Dipl.-Phys.
Mitterhoferstrasse 19
W-8000 München 21(DE)**

**Beschreibung**

Die Erfindung betrifft einen integrierten Halbleiterspeicher mit eingebauter Paralleltesteinrichtung.

Aus IEEE International Solid-State Circuits Conference 1981, Seiten 84 bis 85 und aus Elektronik, Nr. 15, 30.7.1982, Seiten 27 bis 30 ist bekannt, bei integrierten Halbleiterspeichern einen gesamten Speicherbereich, der dem Anwender gegenüber 1-Bit breite Datenschnittstellen für Datenein- und -ausgabe hat, in n einander gleiche Zellenfelder aufzuteilen. Dazu ist es üblich, jedem Zellenfeld speicherintern eine eigene Datenleitung zuzuordnen, die alle über eine erste Datenweiche mit einem Dateneingangsanschluß verbunden sind. Im Betrieb erfolgt die Auswahl, welche der n Datenleitungen auf den Dateneingangsanschluß durchgeschaltet werden soll, über den bzw. eine entsprechende Anzahl von höchstwertigen Adreßeingang (-eingängen). Analog dazu sind die n Datenleitungen mit einem Datenausgangsanschluß über eine zweite Datenweiche verbunden.

Der Wert von n ist geradzahlig. Er ist weiterhin gleich der Anzahl der gewünschten Zellenfelder und hängt davon ab, ob an Adreßeingängen, über die der Halbleiterspeicher ja bekanntlich adressiert wird, einfache Adreßsignale, d.h. nur sogenannte X-Adressen bzw. Y-Adressen angelegt werden, oder aber solche Adreßsignale, die innerhalb einer Taktperiode des Halbleiterspeichers nacheinander sowohl eine X-Adresse als auch eine Y-Adresse enthalten (Adreßmultiplexing). In diesem Fall kann n nur eine durch 4 teilbare Zahl sein.

Des weiteren sind auch Halbleiterspeicher bekannt, die mehr als 1-Bit breite Datenschnittstellen für Datenein- und -ausgabe haben. Typische Organisationsformen dazu sind Datenschnittstellen in einer Breite von m = 4, 8 und 9 Bit.

Solcher Art gestaltete Halbleiterspeicher enthalten aufgrund der fortschreitenden Integrationsmöglichkeiten immer mehr Speicherzellen. Die Zunahme an Speicherzellen je Halbleiterspeicher bedingt jedoch sowohl bei dessen Hersteller als auch beim Kunden, der ja in aller Regel eine sogenannte "incoming inspection" durchführt, einen erhöhten zeitlichen, personellen und finanziellen Aufwand zur Prüfung (Testen) von Halbleiterspeichern. Aufgrund der speziellen, notwendigen Ausgestaltung von Prüfmustern für das Testen steigt die zum Testen notwendige Zeit sogar exponentiell mit der Zunahme an Speicherzellen an. Aus diesem Grunde ist es wünschenswert, die Prüfzeit deutlich verkürzen zu können, ohne die verwendeten Prüfmuster in ihrer Effizienz beschneiden zu müssen. Frühere Versuche mit integrierten Schaltkreisen, bei denen mehrere Halbleiterchips bzw. -bausteine parallel von einem Prüfautomaten getestet wurden, ergaben zwar eine hervorragende Prüfzeitverkürzung, der notwendige mechanische Aufwand dazu (Prüfspitzen auf Scheibenebene, Meßfassungen mit Kabeln, auf Bausteinebene) war jedoch sehr groß. Außerdem mußten vorhandene Prüfprogramme auf komplizierte Art und Weise angepaßt werden.

Aus "1985 IEEE International Solid-State Circuits Conference", 15. Feb. 1985, S. 240-241, 352 ist ein integrierter Halbleiterspeicher bekannt mit einer Paralleltesteinrichtung, bei der im Testfall ein Testdatum parallel in vier verschiedene Speicherzellen einschreibbar und wieder auslesbar ist. Zu diesem Zweck sind ein 4-faches bidirektionales Transfergate, welches mittels eines Testsignales vom Normalbetrieb in den Testbetrieb umschaltbar ist, sowie ein 4-fach-AND-Gatter zum Auswerten der ausgelesenen Daten und eine Datenweiche am Ausgang des AND-Gatters zum Umschalten zwischen Normal- und Testbetrieb vorgesehen. Damit läßt sich die notwendige Testzeit gegenüber einem integrierten Halbleiterspeicher ohne eine solche Einrichtung auf ein 1/4 reduzieren. Nachteilig ist jedoch eine damit verbundene Beschränkung der anwendbaren Testmuster auf Testmuster, die bei jedem Auslesevorgang ausschließlich Daten mit dem Wert "log. 1" enthalten.

Aus "IBM Technical Disclosure Bulletin", Vol. 22, Nr. 10, March 1980, S. 4564-4565 ist ein CCD-Speicher mit Paralleltesteinrichtung bekannt, bei dem eine Auswerteschaltung zwei NOR-Gatter enthält, denen die ausgelesenen Testdaten sowie dazu komplementäre Daten zugeführt werden. Im Fehlerfall nimmt ein zugeordneter Ausgang einen hochohmigen Zustand an ("Tristate").

Aus der EP-A-0 127 015 ist ein integrierter Halbleiterspeicher mit redundanten Speicherzellen bekannt. Um in einem Testbetrieb erkennen zu können, ob redundante Speicherzellen aktiviert sind oder nicht, enthält dieser Halbleiterspeicher eine entsprechende Schaltung, die durch ein Steuersignal aktivierbar ist. Dieses ist über einen Signaleingang zuführbar, an dem im Normalbetrieb ein für diesen übliches Signal anliegt, beispielsweise ein Adreßsignal. Im Testbetrieb liegt jedoch das Steuersignal an, welches einen gegenüber den logischen Pegeln des Adreßsignals überhöhten Spannungspegel aufweist. Damit können Schaltungsteile im Halbleiterspeicher die beiden Signalarten voneinander unterscheiden.

Es ist Aufgabe der vorliegenden Erfindung, einen integrierten Halbleiterspeicher mit integrierter Paralleltesteinrichtung zu schaffen, der es ermöglicht, die Prüfzeit ohne Verlust an Effizienz der eingesetzten Prüfmuster deutlich zu verkürzen unter Verwendung einer neuartigen Auswerteschaltung.

Diese Aufgabe wird erfindungsgemäß gelöst durch die in den Patentansprüchen 1 und 5 angegebenen Merkmale. Grundgedanke der Erfindung ist dabei, einen Halbleiterspeicher so auszugestalten, daß er zwar einerseits wie üblich (Normalfall) betrieben werden kann, es jedoch andererseits (Testfall) möglich ist, Teilbereiche des Halbleiterspeichers speicherintern parallel zu schalten und sowohl ausgelesene Daten als auch ev. aufgetretene Fehler meßtechnisch an einem Speicheranschluß (-pad, -pin) erfassen zu können.

Vorteilhafte Weiterbildungen und Ausprägungen der Erfindung sind in Unteransprüchen gekennzeichnet. Die Erfindung ist u.a. anwendbar sowohl auf DRAM's und SRAM's als auch auf EPROM's und EEPROM's.

Im folgenden wird die Erfindung anhand von Figuren näher beschrieben. Es zeigen:

Fig. 1    eine erste Ausführungsform der Erfindung,

Fig. 2    eine spezielle Ausgestaltung einer Auswerteschaltung AS,

Fig. 3    eine zweite Ausführungsform der Erfindung,

Fig. 4    eine dritte Ausführungsform der Erfindung,

Fig. 5    die erste Ausführungsform der Erfindung, angewandt auf einen Speicher mit acht Zellenfeldern,

Fig. 6    die erste Ausführungsform der Erfindung, angewandt auf einen Speicher mit Datenschnittstellen in einer Breite von 2 Bit,

Fig. 7    ein Zeitdiagramm,

Fig. 8    eine weitere, vorteilhafte Ausgestaltung einer Auswerteschaltung AS.

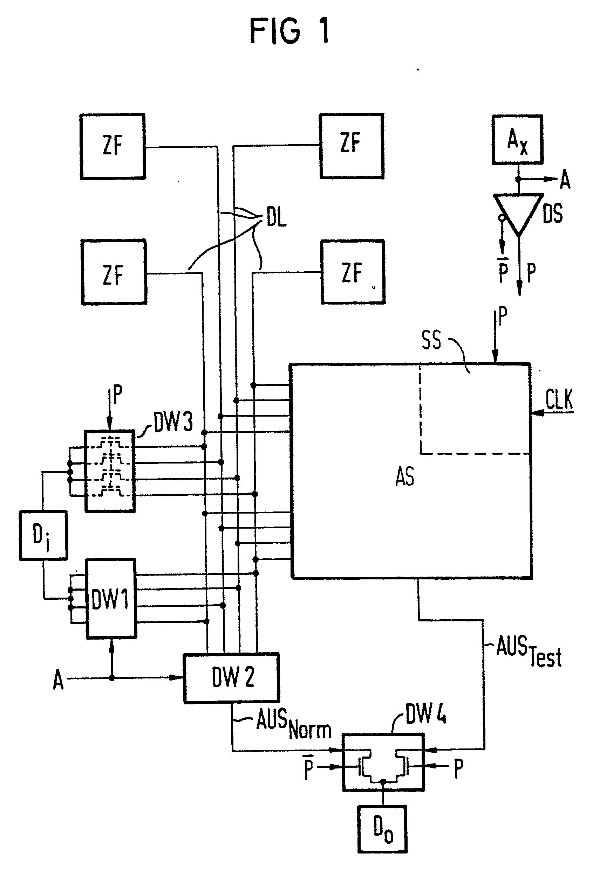

Gemäß Fig. 1 enthält ein erfindungsgemäßer Halbleiterspeicher mit $m = 1$ Dateneingangsanschluß $D_i$ und $m = 1$ Datenausgangsanschluß $D_o$ $n = 4$ einander gleiche Zellenfelder ZF (z. B. bei einem "Megabit"-Speicher: Gesamtanzahl der Speicherzellen: $1024\ k \cdot 1\ Bit = 1\ M \cdot 1\ Bit$, dies ergibt bei $n = 4$ vier Zellenfelder ZF à $256\ k \cdot 1\ Bit$). An jedes Zellenfeld ZF ist eine von n Datenleitungen DL angeschlossen. Diese dienen dem Einschreiben von Informationen in die Zellenfelder ZF bzw. zu deren Auslesen. In bekannter Weise sind diese $n = 4$ Datenleitungen DL über eine erste Datenweiche DW1 mit dem Dateneingangsanschluß $D_i$ verbunden. Zum Einschreiben von Information in den Speicher wird durch Ansteuerung der ersten Datenweiche DW1 mittels einer bestimmten Adresseninformation, nämlich einem Adressierungssignal A, das am höchstwertigen $(A_x)$ von vorhandenen Adreßanschlüssen liegt, im Normalbetrieb die am Dateneingangsanschluß $D_i$ anliegende Information auf eine der $n = 4$ vorhandenen Datenleitungen DL geschaltet, von wo aus sie in das entsprechende Zellenfeld ZF eingeschrieben wird. Entsprechend dazu sind die Datenleitungen DL über eine zweite Datenweiche DW2 mit dem Datenausgangsanschluß $D_o$ verbunden. Diese wird adressierungsmäßig genauso angesteuert wie die erste Datenweiche DW1. Sie schaltet eine der n Datenleitungen DL auf den Datenausgangsanschluß $D_o$. Diese bisher beschriebenen Teile eines erfindungsgemäßen Halbleiterspeichers sind für sich allein bereits bekannt. Sie finden beispielsweise Anwendung in Halbleiterspeichern, die die sogenannten "Nibble-Mode"-Betriebsweise erlauben.

Der erfindungsgemäße Halbleiterspeicher enthält nun in vorteilhafter Art und Weise, parallel zur ersten Datenweiche DW1 eine dritte Datenweiche DW3, mittels derer im Testbetrieb am Dateneingangsanschluß $D_i$ anliegende Informationen gleichzeitig auf alle $n = 4$ Datenleitungen DL übergeben werden. Die dritte Datenweiche DW3 kann beispielsweise $n = 4$ parallel geschaltete Transistoren enthalten, deren eine Seite ihrer Durchlaßstrecken gemeinsam an den Dateneingangsanschluß $D_i$ angeschlossen sind und deren andere Seiten an je eine Datenleitung DL angeschlossen sind. Gatemäßig angesteuert werden die Transistoren der dritten Datenweiche DW3 durch ein Steuersignal P, dessen Erzeugung später beschrieben wird. Schreibt man über diese dritte Patenweiche DW3 Informationen in die Zellenfelder ZF, so enthalten diese Zellenfelder ZF untereinander dieselben Informationen.

Betrachtet man nun im Testbetrieb jedes der Zellenfelder ZF als einen eigenen Speicher (Prüfling), so kann man die (Test-)Informationen, die adressierungsmäßig auf ein Zellenfeld ZF abgestimmt sein müssen, gleichzeitig parallel in alle Zellenfelder ZF einschreiben.

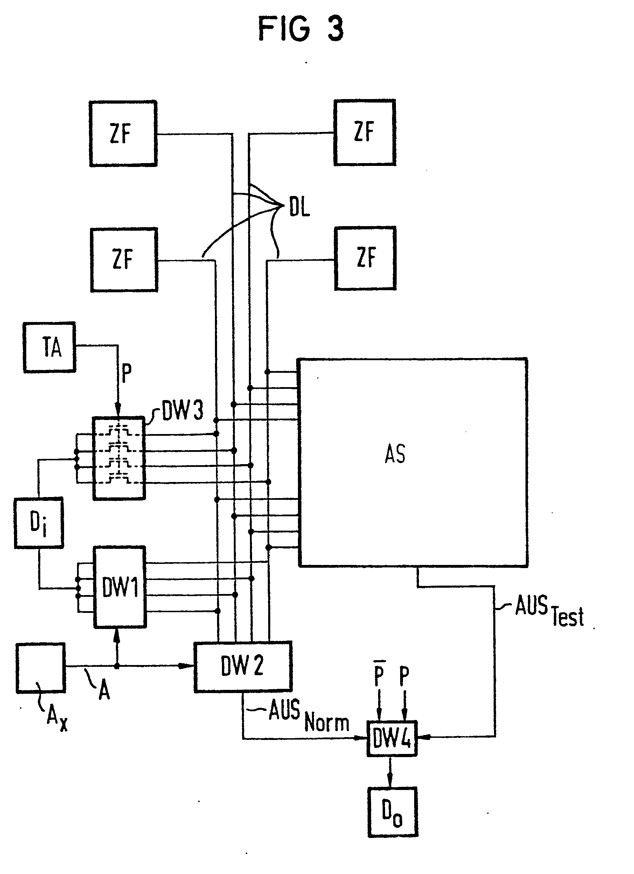

Das Steuersignal P, das die dritte Datenweiche DW3 aktiviert, kann auf verschiedene Arten gewonnen werden. In einer Ausführungsform gemäß Fig. 3 wird im Testfall an einen weiteren Anschluß TA ein Testsignal in Form eines konstanten Potentiales (z.B. log. '1') angelegt. Im Normalbetrieb wird entweder ein konstantes Potential z.B. mit dem Wert log. '0' angelegt oder aber der Anschluß TA bleibt unbeschaltet. Das so erzeugte Steuersignal P, das direkt am Anschluß TA abgegriffen werden kann, steuert dann u.a. die Gates der dritten Datenweiche DW3 an, so daß deren Transistoren durchschalten. Diese Lösung hat einerseits den Vorteil, einen Potentialwert wählen zu können, der sonst auch zur Ansteuerung des Halbleiterspeichers verwendet wird (z.B. "TTL-Pegel"). Andererseits wird aber für den Anschluß TA ein zusätzlicher Anschluß benötigt, der unter Umständen aufgrund von Gehäuseabmessungen des Halbleiterspeichers nicht verfügbar ist.

In einer anderen Ausführungsform, dargestellt in Fig. 1, wird ein Anschluß mitbenutzt, der ansonsten für den Normalbetrieb benützt wird. Als geeignetster Anschluß bietet sich ein Anschluß an, der der Ansteuerung des Halbleiterspeichers mit Adreßinformationen dient, insbesondere der für die höchstwertige X- bzw. Y- bzw. X/Y-Information (beim heute üblichen Adreßmultiplexverfahren). Im Normalbetrieb wird an einen solchen Anschluß bei heute üblichen Halbleiterspeichern beispielsweise ein (höchstwertiges) Adreßsignal A mit einem '0'-Pegel von 0 Volt und einem '1'-Pegel von 5 Volt angelegt. Bei der Ausführungsform des erfindungsgemäßen Halbleiterspeichers nach Fig. 1 wird dieser Anschluß allgemein mit $A_x$ bezeichnet. An diesem liegt im Normalfall die höchstwertige X/Y-Adreßinformation. Für den Testbetrieb wird ein Potential angelegt, das z.B. deutlich über dem '1'-Pegel des üblichen, am Adressanschluß $A_x$ anliegenden Adreßsignales A liegt, beispielsweise 10 V. Eine nachgeschaltete Diskriminatorschaltung DS erkennt dieses angelegte Potential und erzeugt das halbleiterspeicherinterne Steuersignal P. Diskriminatorschaltungen DS sind als solche an sich bekannt, beispielsweise in Form von Schwellwertschaltern. Bekannte Schwellwertschalter sind z.B. der DE-OS 30 30 852 und der DE-OS 33 18 564 entnehmbar. Es sind jedoch auch andere Ausgestaltungen nach dem Stande der Technik denkbar.

Des weiteren enthält ein erfindungsgemäßer Halbleiterspeicher noch m einander gleiche Auswerteschaltungen AS (m = Breite der Datenschnittstellen für Datenein- und -ausgabe).

Aufgabe jeder dieser Auswerteschaltungen AS ist es, beim Auslesen aus dem Halbleiterspeicher die auf den der jeweiligen Auswerteschaltung AS zugeordneten n Datenleitungen DL anliegende Informationen zu übernehmen und sie in dem Falle, wo alle diese Informationen untereinander gleich sind (was aufgrund von zuvor stattgefundenem parallelem Abspeichern in die Zellenfelder ZF ja dem "Gut-Fall" entspricht), über einen Ausgang $AUS_{Test}$ an den Datenausgangsanschluß $D_o$ weiterzuleiten und in dem Falle, in dem diese Daten einander nicht gleich sind (Fehlerfall), ihren Ausgang $Aus_{Test}$ in einen hochohmigen Zustand zu versetzen. Dadurch nimmt dann auch der Datenausgangsanschluß $D_o$ einen hochohmigen Zustand an, was dann z.B. ein an den Datenausgangsanschluß $D_o$ angeschlossener Prüfautomat als Fehler erkennt.

Wird nun während des Testens des Halbleiterspeichers aufgrund eines an diesen angelegten Prüfmusters eine log. '1' am Datenausgangsanschluß $D_o$ als ausgelesene Information erwartet, so sind folgende drei Fälle möglich:

a) alle Zellenfelder ZF funktionieren richtig: jede der n = 4 Datenleitungen DL erhält von einer gerade angesteuerten Speicherzelle ihres zugeordneten Zellenfeldes ZF eine log. '1', die die Auswerteschaltung AS an den Datenausgangsanschluß $D_o$ weiterreicht und die vom Testautomaten als "gut" erkannt wird.

b) alle Zellenfelder ZF sind an den gerade angesteuerten Speicherzellen defekt (äußerst unwahrscheinlich als Einzelfehler, im allgemeinen fast Totalausfall des Halbleiterspeichers): über die Datenleitungen DL werden nur logische '0'-Signale ausgelesen, die die Auswerteschaltung AS zwar nicht als Fehler erkennt und deshalb als log. '0' an den Datenausgangsanschluß $D_o$ weiterreicht, der Prüfautomat jedoch erkennt den Fehler.

c) 1 bis n-1 Zellenfeld(er) ZF enthält (enthalten) eine fehlerhafte, adressierte Speicherzelle: die Auswerteschaltung AS erkennt dies, versetzt ihr Ausgangssignal $AUS_{Test}$ in den hochohmigen Zustand und versetzt dadurch auch den Datenausgangsanschluß $D_o$ in den hochohmigen Zustand. Der Prüfautomat erkennt den Fehler.

Wird am Datenausgangsanschluß $D_o$ dagegen eine log. '0' erwartet, so ist der Ablauf sinngemäß genauso wie vorstehend im Falle der log. '1' als erwarteter Information.

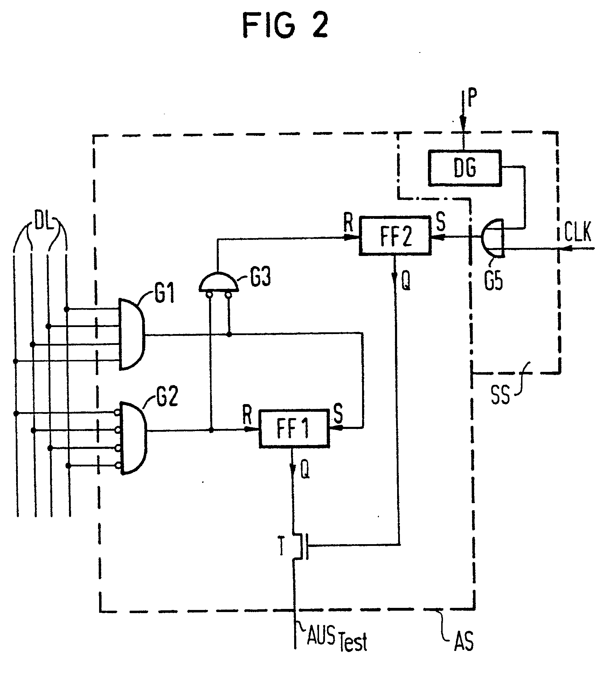

Eine mögliche, vorteilhafte Ausgestaltung der Auswahlschaltung AS ist in Fig. 2 gezeigt. Sie wird nachfolgend erläutert.

Ein erstes UND-Gatter G1 hat n = 4 Eingänge. Diese sind mit je einer der n = 4 Datenleitungen DL verbunden. Ein zweites UND-Gatter G2 ist dem ersten UND-Gatter G1 eingangsmäßig parallel geschaltet. Seine ebenfalls n = 4 Eingänge sind jedoch negiert, so daß das zweite UND-Gatter G2 wie eine NOR-Funktion wirkt. Das erste UND-Gatter G1 schaltet an seinem Ausgang nur dann auf log. "1", wenn alle Datenleitungen DL auf log. "1" liegen. Analoges gilt für den Ausgang des zweiten UND-Gatters G2 (Ausgang nur dann log. "1", wenn alle Datenleitungen DL auf log. "0").

Die Auswerteschaltung AS enthält des weiteren eine erste Kippschaltung FF1, beispielsweise in Form eines RS-Flip-Flops mit Set- und Reseteingang S,R, sowie einem Ausgang. Der Seteingang S ist mit dem Ausgang des ersten UND-Gatters G1 verbunden und setzt den Ausgang der ersten Kippschaltung FF1 auf log. "1", wenn an allen Eingängen des ersten UND-Gatters G1 eine log. "1" anliegt. Analog dazu ist der Reseteingang R mit dem Ausgang des zweiten UND-Gatters G2 verbunden. Der Ausgang wird also gesetzt, wenn auf allen n = 4 Datenleitungen DL eine logische "1" anliegt und rückgesetzt, wenn ensprechend an allen Datenleitungen DL eine log. "0" anliegt. Im Fehlerfall liegt keine dieser Konditionen vor, die erste Kippschaltung FF1 ändert ihren Ausgang nicht.

Parallel zum Anschluß an die beiden Eingänge der ersten Kippschaltung FF1 sind die Ausgänge der beiden UND-Gatter G1, G2 in negierter Form an ein drittes UND-Gatter G3 angeschlossen. Dieses wirkt also ebenfalls als NOR-Funktion. Der Ausgang des dritten UND-Gatters G3 ist nur dann auf log. "1", wenn ein Fehler vorliegt, d.h. wenn nicht alle n = 4 Datenleitungen DL denselben logischen Pegel ("0" oder "1") besitzen. In diesem Fehlerfall setzt er als Reseteingang R eine zweite Kippschaltung FF2 zurück, die im Aufbau gleich der ersten Kippschaltung FF1 sein kann. Die zweite Kippschaltung FF2 weist auch einen als Seteingang S ausgebildeten weiteren Eingang auf. Dieser wird von einer Setschaltung SS gesteuert.

Die zweite Kippschaltung FF2 besitzt einen Ausgang, der vom Seteingang S auf log. "1" und vom Reseteingang R auf log. "0" gesetzt wird. Da der Reseteingang R immer im Fehlerfall aktiviert wird, kann man auch folgendes sagen: Der Ausgang der zweiten Kippschaltung FF2 wird im Fehlerfall zurückgesetzt (= auf log. "0"), ansonsten ist er gesetzt (log. "1").

Der Ausgang der ersten Kippschaltung FF1 ist mit dem Sourceanschluß eines Transistors T verbunden. Der Ausgang der zweiten Kippschaltung FF2 ist mit dem Gate des Transistors T verbunden. An der Drain des Transistors T entsteht das Ausgangssignal $AUS_{Test}$ der Auswerteschaltung AS. Unter der beispielhaften Annahme, daß der Transistor vom n-Kanal-Enhancement-Typ ist, ist dieser immer dann durchgeschaltet, wenn der Ausgang der zweiten Kippschaltung FF2 gesetzt (= log.'1') ist. Dann wird das am Ausgang der ersten Kippschaltung FF1 anliegende Signal als Ausgangssignal $AUS_{Test}$ der Auswerteschaltung AS an den Datenausgangsanschluß $D_0$ weitergereicht. Ist der Ausgang der zweiten Kippschaltung FF2 aufgrund eines erkannten Fehlers, wie bereits beschrieben, zurückgesetzt (= log.'0'), so wird der Transistor T gesperrt und das Ausgangssignal $AUS_{Test}$ der Auswerteschaltung AS nimmt seinen hochohmigen Zustand an.

Die Setschaltung SS, die ja mit ihrem Ausgang den Seteingang S der zweiten Kippschaltung FF2 bildet, soll also das Durchschalten des Transistors T ermöglichen, sofern kein Fehler von der Auswerteschaltung AS erkannt wird.

Dies kann dadurch geschehen, daß innerhalb jeder Taktperiode TP gleich zu deren Beginn ein im Halbleiterspeicher sowieso vorhandener Maschinentakt CLK an den Seteingang S der zweiten Kippschaltung FF2 angelegt wird. Damit wird die Setschaltung SS praktisch auf die Zuführung des Maschinentaktes CLK reduziert. Es ist selbstverständlich auch möglich, den Maschinentakt CLK der Setschaltung SS auch extern über einen Bausteinanschluß, z.B. vom angeschlossenen Testautomaten her, zuzuführen.

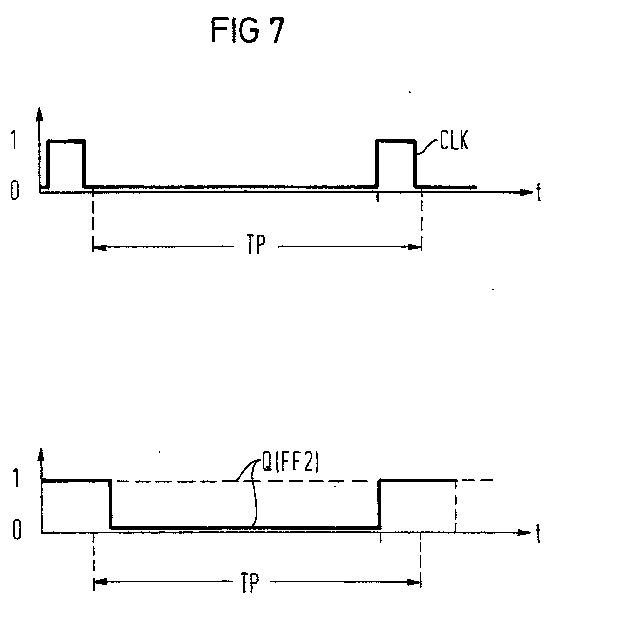

Es ist aber auch möglich, den Maschinentakt CLK erst am Ende der Taktperiode TP, d.h. also z.B. nach erfolgtem Bewerten im Testautomaten, sozusagen als Vorbereitung für die nächste Taktperiode TP zuzuführen (vgl. Fig. 7). Dann ist es jedoch notwendig, sofort nach Aktivieren des Steuersignales P und gegebenenfalls sofort nach Anlegen einer Versorgungsspannung an den Halbleiterspeicher die zweite Kippschaltung FF2 zu setzen. Dies kann, wie in Fig. 2 gezeigt, dadurch erreicht werden, daß das Steuersignal P über ein übliches Differenzierglied DG auf einen Eingang eines ODER-Gatters gegeben wird, dessen anderer Eingang mit dem Maschinentakt CLK verbunden ist. Der Ausgang des ODER-Gatters, der gleichzeitig Ausgang der Setschaltung SS ist, wirkt dann als Seteingang S der zweiten Kippschaltung FF2 und setzt deren Ausgang bei jedem Taktzyklus TP.

Falls von der Auswerteschaltung AS ein Fehler erkannt wird, wird, wie bereits beschrieben, über den Reseteingang R der zweiten Kippschaltung FF2 deren Ausgang rückgesetzt (= log."0"), so daß der Transistor T gesperrt wird. Damit wird das Ausgangssignal $AUS_{Test}$ hochohmig, infolgedessen nimmt auch der Datenausgangsanschluß $D_0$ einen hochohmigen Zustand an.

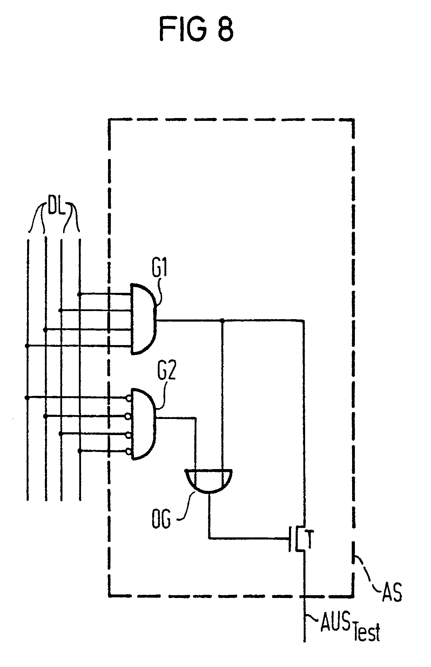

Fig. 8 zeigt eine weitere, vorteilhafte Ausführungsform der Auswerteschaltung AS. Sie weist gegenüber der Ausführungsform nach Fig. 2 wesentliche schaltungstechnische Vereinfachungen auf. Sie enthält neben den von der Ausführungsform gemäß Fig. 2 her bereits bekannten beiden UND-Gattern G1 und G2 und dem Transistor T lediglich noch ein ODER-Gatter OG. Die Source des Transistors T ist direkt mit dem Ausgang des ersten UND-Gatters G1 verbunden. An der Drain des Transistors T entsteht wiederum das Ausgangssignal $AUS_{Test}$. Das Gate des Transistors T ist mit dem Ausgang des ODER-Gatters OG verschaltet. Je ein Eingang des ODER-Gatters OG ist mit einem Ausgang der beiden UND-Gatter G1,G2 verbunden.

Die Funktionsweise dieser vorteilhaften Ausgestaltung der Auswerteschaltung AS ist sehr einfach:

Fall 1): An allen n Datenleitungen DL liegt eine logische '1':

Der Ausgang des ersten UND-Gatters G1 liegt auf logisch '1', ebenso der Ausgang des ODER-Gatters OG. Dadurch wird der Transistor T durchgeschaltet, das Signal $AUS_{Test}$ nimmt den Wert log. '1' an.

Fall 2): An allen Datenleitungen DL liegt eine logische '0' an:

Der Ausgang des ersten UND-Gatters G1 liegt auf log. '0', der Ausgang des zweiten UND-Gatters G2 liegt jedoch auf log. '1'. Damit liegt auch der Ausgang des ODER-Gatters OG auf log. '1', der Transistor T wird durchgeschaltet, das Ausgangssignal $AUS_{Test}$ nimmt den Wert log. '0' an.

Fall 3): An einer bis n-1 der Datenleitungen DL liegt ein anderer logischer Wert an als an den restlichen der n Datenleitungen DL:

Die Ausgänge beider UND-Gatter G1,G2 sind auf log. '0'. Der Ausgang des ODER-Gatters ist demzufolge auch auf log. '0', d.h. der Transistor T ist gesperrt. Damit jedoch nimmt das Ausgangssignal $AUS_{Test}$ bestimmungsgemäß seinen hochohmigen Zustand an.

Die Ausführungsform der Erfindung nach Fig. 1 weist auf vorteilhafte Weise noch je Bit der Breite m der Datenschnittstellen eine vierte Datenweiche DW4 auf, die dazu dient, auf den Datenausgangsanschluß $D_o$ im Normalbetrieb die aus der jeweiligen zweiten Datenweiche DW2 austretenden Informationen $AUS_{Norm}$ auf den jeweiligen Datenausgangsanschluß $D_o$ zu schalten und im Testbetrieb statt dessen das Ausgangssignal $AUS_{Test}$ der jeweiligen Auswerteschaltung AS mit dem entsprechenden DO-Anschluß $D_o$ zu verbinden. Diesem Zwecke dienen je vierter Datenweiche DW4 zwei Transistoren. Deren Source-Anschlüsse sind gemeinsam mit dem zugehörigen Datenausgangsanschluß $D_o$ verbunden. Der Drainanschluß des einen Transistors ist mit dem Ausgang der zweiten Datenweiche DW2 verbunden, während der Drainanschluß des anderen Transistors mit dem Ausgang der Auswerteschaltung AS verbunden ist. Der eine Transistor wird gatemäßig von einem zum Steuersignal P komplementären Signal P angesteuert; der andere vom Steuersignal P. Damit ist es möglich, wahlweise den Ausgang der zweiten Datenweiche DW2 oder den der Auswerteschaltung AS auf den Datenausgangsanschluß $D_o$ zu schalten.

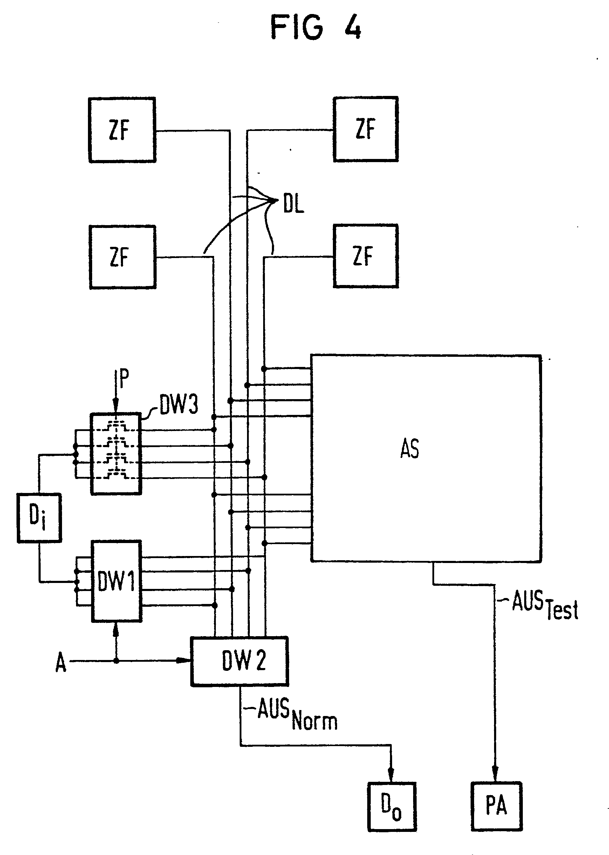

Es ist jedoch in einer anderen Ausführungsform durchaus auch möglich, den Ausgang jeder der zweiten Datenweichen DW2 direkt auf den zugehörigen Datenausgangsanschluß $D_o$ zu schalten und den Ausgang jeder Auswerteschaltung AS, ebenfalls direkt, separat auf einen eigenen Anschluß PA im Sinne eines Prüfanschlusses zu legen. Diese Ausführungsform ist in Fig. 4 gezeigt.

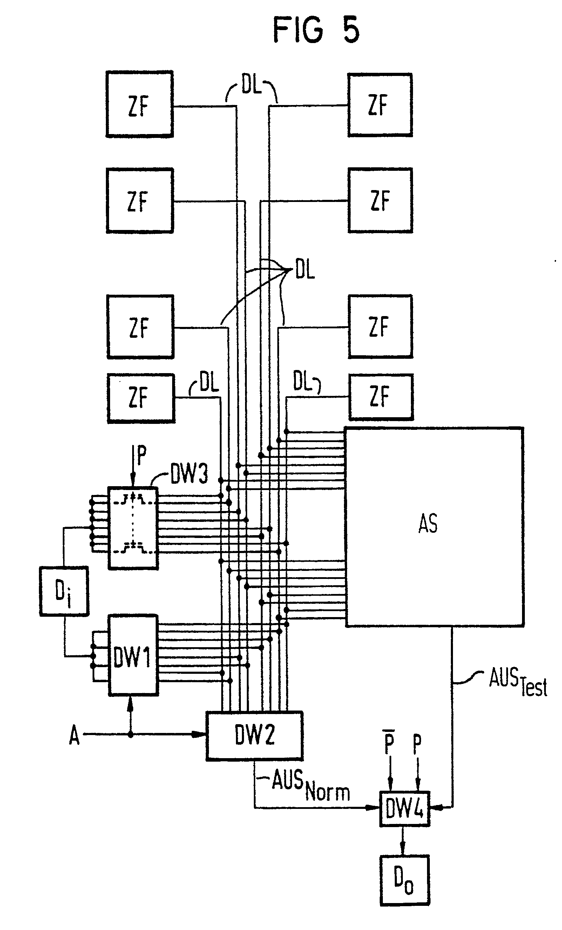

Fig. 5 zeigt eine Ausführungsform eines erfindungsgemäßen Halbleiterspeichers, bei dem anstelle von n = 4 Zellenfelder ZF n = 8 Zellenfelder ZF verwendet werden. Die Funktion des Halbleiterspeichers ist dieselbe wie für Fig. 1 beschrieben. Es tritt jedoch im Testbetrieb eine noch stärkere Reduzierung der Testzeit ein.

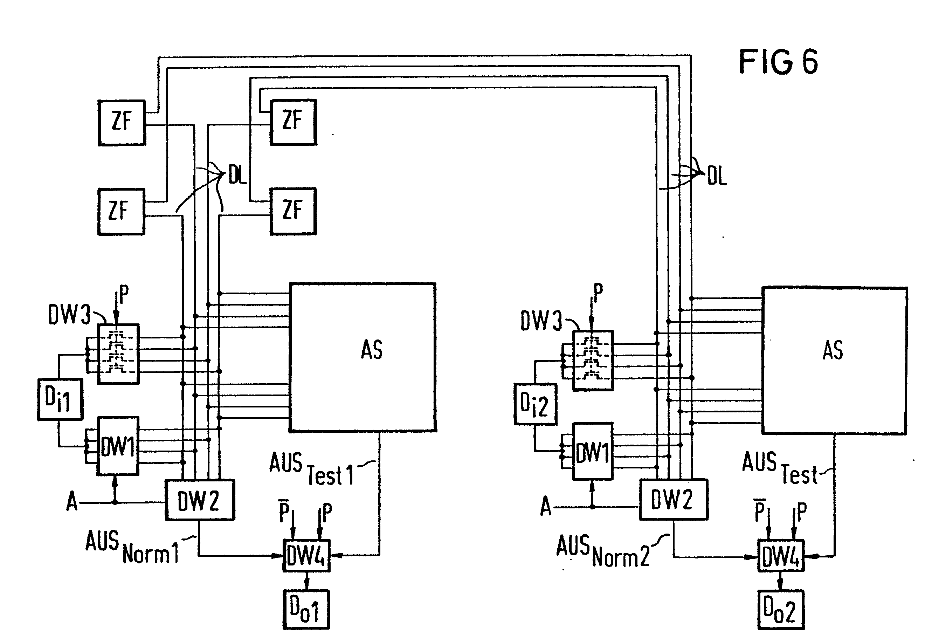

Fig. 6 zeigt eine Ausführungsform eines erfindungsgemäßen Halbleiterspeichers, bei dem wiederum n = 4 Zellenfelder ZF verwendet sind, der jedoch eine Breite von m = 2 Bit bei den Datenschnittstellen besitzt. Die Funktion ist dieselbe, wie in Fig. 1 beschrieben. Es ist lediglich klarzustellen, daß jeweils beide dargestellte erste Datenweichen DW1, zweite Datenweichen DW2, dritte Datenweichen DW3 und vierte Datenweichen DW4, die Zellenfelder ZF sowie die beiden Auswerteschaltungen AS jeweils zueinander parallel und unabhängig voneinander arbeiten. Zur Verdeutlichung der Tatsache, daß die Datenschnittstellen der m = 2 Bits voneinander unabhängige Informationen führen, wurden an Stelle der Bezeichnungen $D_i$ $D_o$, $AUS_{Test}$, $AUS_{Norm}$, die Bezeichnungen $D_{i1}$, $D_{o1}$, $D_{i2}$, $D_{o2}$, $AUS_{Test1}$, $AUS_{Test2}$, $AUS_{Norm1}$ und $AUS_{Norm2}$ gewählt.

## Patentansprüche

1. Integrierter Halbleiterspeicher, der folgende Merkmale aufweist:
   - n einander gleiche Speicherzellenfelder (ZF), - n . m Datenleitungen (DL) zum Einschreiben und Auslesen von Speicherdaten in die bzw. aus den Speicherzellenfeldern (ZF),
   - m erste Datenweichen (DW1), von denen jede beim Einschreiben an einem ihr zugeordneten Dateneingangsanschluß ($D_i$) anliegende, in den Halbleiterspeicher einzuschreibende Speicherdaten in Abhängigkeit von Adressierungsdaten an jeweils eine der n ihr zugehörigen Datenleitungen (DL) anlegt,
   - m zweite Datenweichen (DW2), von denen jede beim Auslesen von Speicherdaten, die auf jeweils n Datenleitungen (DL) anliegen, in Abhängigkeit von Adressierungsdaten eine der n Datenleitungen (DL) auswählt und über einen Ausgang an einen zugehörigen Datenausgangsanschluß ($D_o$) anlegt,
   - an jeweils n der n . m Datenleitungen (DL) ist, parallel zu der jeweiligen zweiten Datenweiche (DW2), eine Auswerteschaltung (AS) angeschlossen mit einem Ausgangssignal ($AUS_{Test}$), das entweder die aus den Speicherzellenfeldern (ZF) ausgelesenen Speicherdaten beinhaltet oder, im Falle des Auftretens von mindestens einem und höchstens n-1 fehlerhaften Speicherdaten, einen hochohmigen Zustand aufweist,
   - zwischen jedem der m Dateneingangsanschlüsse ($D_i$) und den zugehörigen n von n . m Datenleitungen (DL) ist, parallel zur jeweiligen ersten Datenweiche (DW1), eine dritte Datenweiche (DW3) geschaltet, die in Abhängigkeit von einem Steuersignal (P) die in den Halbleiterspeicher einzuschreibenden Speicherdaten parallel an alle n Datenleitungen (DL) übergibt,
   - jedem der m Datenausgangsanschlüsse ($D_o$) ist eine vierte Datenweiche (DW4) vorgeschaltet, die in Abhängigkeit vom Steuersignal (P) und einem zu diesem komplementären Signal ($\overline{P}$) entweder das von der zweiten Datenweiche (DW2) ausgewählte Speicherdatum ($AUS_{Norm}$) oder das von der Auswerteschaltung (AS) erzeugte Ausgangssignal (AUS$_{Test}$) an den Datenausgangsanschluß (D$_o$) durchschaltet, wobei in dem Fall, in dem das von der Auswerteschaltung (AS) erzeugte Ausgangssignal (AUS$_{Test}$) den hochohmigen Zustand aufweist, auch der Datenausgangsanschluß (D$_o$) einen hochohmigen Zustand aufweist,

- für das Steuersignal (P) ist ein weiterer Anschluß (A$_x$; TA) vorgesehen,
- jede Auswerteschaltung (AS) enthält zum Durchschalten der aus den Speicherzellenfeldern (ZF) ausgelesenen Speicherdaten eine erste Kippschaltung (FF1) mit zwei Eingängen und einem Ausgang, deren erster Eingang, genannt Seteingang (S), aktiviert wird, wenn alle an die Auswerteschaltung (AS) angeschlossenen n Datenleitungen (DL) im Gutfall einen ersten logischen Zustand aufweisen, und deren zweiter Eingang, genannt Reseteingang (R), aktiviert wird, wenn alle an die Auswerteschaltung (AS) angeschlossenen n Datenleitungen (DL) im Gutfall einen zum ersten logischen Zustand komplementären zweiten logischen Zustand aufweisen, so daß in dem Falle, in dem alle besagten n Datenleitungen (DL) denselben ersten oder zweiten logischen Zustand besitzen, der Ausgang der ersten Kippschaltung (FF1) gezielt gesetzt bzw. rückgesetzt wird,
- für den Fehlerfall, in dem alle an die Auswerteschaltung (AS) angeschlossenen n Datenleitungen (DL) gemeinsam weder den ersten noch den zweiten logischen Zustand besitzen, ist eine zweite Kippschaltung (FF2) vorgesehen mit zwei Eingängen und einem Ausgang, deren einer Eingang, genannt Reseteingang (R), im Fehlerfalle den Ausgang der zweiten Kippschaltung (FF2) zurücksetzt und deren anderer Eingang, genannt Seteingang (S), zum Setzen des Ausgangs der zweiten Kippschaltung (FF2) über den Ausgang einer Setschaltung (SS) angesteuert wird.

2. Integrierter Halbleiterspeicher nach Anspruch 1, **dadurch gekennzeichnet,** daß der Ausgang der Setschaltung (SS) aktiviert wird zum einen bei einem Aktivieren des Steuersignales (P) oder beim Anlegen einer Betriebsspannung an den Halbleiterspeicher durch ein Differenzierglied (DG), und zum anderen mittels eines Maschinentaktes (CLK).

3. Integrierter Halbleiterspeicher nach Anspruch 1 oder 2, **dadurch gekennzeichnet,** daß mittels des Seteingangs (S) der zweiten Kippschaltung (FF2) deren Ausgang zu Beginn einer jeden Taktperiode (TP) gesetzt wird.

4. Integrierter Halbleiterspeicher nach einem der Ansprüche 1 bis 3, **dadurch gekennzeichnet,** daß das Ausgangssignal (AUS$_{Test}$) jeder Auswerteschaltung (AS) mittels eines Transistors (T) erzeugt wird, dessen Source mit dem Ausgang der ersten Kippschaltung (FF1) verbunden ist, dessen Drain das Ausgangssignal (AUS$_{Test}$) aufweist und dessen Gate mit dem Ausgang der zweiten Kippschaltung (FF2) verbunden ist.

5. Integrierter Halbleiterspeicher, der folgende Merkmale aufweist:
- n einander gleiche Speicherzellenfelder (ZF),
- n . m Datenleitungen (DL) zum Einschreiben und Auslesen von Speicherdaten in die bzw. aus den Speicherzellenfeldern (ZF),
- m erste Datenweichen (DW1), von denen jede beim Einschreiben an einem ihr zugeordneten Dateneingangsanschluß (D$_i$) anliegende, in den Halbleiterspeicher einzuschreibende Speicherdaten in Abhängigkeit von Adressierungsdaten an jeweils eine der n ihr zugehörigen Patenleitungen (DL) anlegt,
- m zweite Datenweichen (DW2), von denen jede beim Auslesen von Speicherdaten, die auf jeweils n Datenleitungen (DL) anliegen, in Abhängigkeit von Adressierungsdaten eine der n Datenleitungen (DL) auswählt und über einen Ausgang an einen zugehörigen Datenausgangsanschluß (D$_o$) anlegt,
- an jeweils n der n . m Datenleitungen (DL) ist, parallel zu der jeweiligen zweiten Datenweiche (DW2), eine Auswerteschaltung (AS) angeschlossen mit einem Ausgangssignal (AUS$_{Test}$),das entweder die aus den Speicherzellenfeldern (ZF) ausgelesenen Speicherdaten beinhaltet oder, im Falle des Auftretens von mindestens einem und höchstens n-1 fehlerhaften Speicherdaten, einen hochohmigen Zustand aufweist,
- zwischen jedem der m Dateneingangsanschlüsse (D$_i$) und den zugehörigen n von n . m Datenleitungen (DL) ist, parallel zur jeweiligen ersten Datenweiche (DW1), eine dritte Datenweiche (DW3) geschaltet, die in Abhängigkeit von einem Steuersignal (P) die in den Halbleiterspeicher einzuschreibenden Speicherdaten parallel an alle n Datenleitungen (DL) übergibt,

- jedem der m Datenausgangsanschlüsse ($D_o$) ist eine vierte Datenweiche (DW4) vorgeschaltet, die in Abhängigkeit vom Steuersignal (P) und einem zu diesem komplementären Signal ($\overline{P}$) entweder das von der zweiten Datenweiche (DW2) ausgewählte Speicherdatum ($AUS_{Norm}$) oder das von der Auswerteschaltung (AS) erzeugte Ausgangssignal ($AUS_{Test}$) an den Datenausgangsanschluß ($D_o$) durchschaltet, wobei in dem Fall, in dem das von der Auswerteschaltung (AS) erzeugte Ausgangssignal ($AUS_{Test}$) den hochohmigen Zustand aufweist, auch der Datenausgangsanschluß ($D_o$) einen hochohmigen Zustand aufweist,
- für das Steuersignal (P) ist ein weiterer Anschluß ($A_x$; TA) vorgesehen,
- die Auswerteschaltung (AS) weist zwei UND-Gatter (G1,G2) mit jeweils n Eingängen und einem Ausgang auf,
- die Eingänge des zweiten UND-Gatters (G2) sind invertiert,
- der Ausgang des ersten UND-Gatters (G1) ist mit der Source eines Transistors (T) verbunden, an dessen Drain das Ausgangssignal ($AUS_{Test}$) der Auswerteschaltung (AS) entsteht,
- das Gate des Transistors (T) ist mit dem Ausgang eines zwei Eingänge aufweisenden ODER-Gatters (OG) verbunden,
- der eine Eingang des ODER-Gatters (OG) ist mit dem Ausgang des ersten UND-Gatters (G1) verbunden und der zweite Eingang des ODER-Gatters (OG) ist mit dem Ausgang des zweiten UND-Gatters (G2) verbunden.

6. Integrierter Halbleiterspeicher nach einem der vorhergehenden Ansprüche, **dadurch gekennzeichnet,** daß jede der dritten Datenweichen (DW3) n Transistoren enthält, die mit ihrer Durchlaßstrecke einerseits alle an den zugehörigen Dateneingangsanschluß ($D_i$) und andererseits an je eine der n zu dem jeweiligen Dateneingangsanschluß ($D_i$) gehörigen Datenleitung (DL) angeschlossen sind, und deren Gates parallel an das Steuersignal (P) angeschlossen sind.

7. Integrierter Halbleiterspeicher nach einem der vorhergehenden Ansprüche, **dadurch gekennzeichnet,** daß jede der m vierten Datenweichen (DW4) Zwei Transistoren enthält, daß die Drainanschlüsse der beiden Transistoren zusammengeschaltet sind und mit dem der jeweiligen vierten Datenweiche (DW4) zugehörigen Datenausgangsanschluß ($D_o$) verbunden sind, daß bei jeder der vierten Datenweichen (DW4) der eine Transistor mit seinem Sourceanschluß mit dem Ausgang der zugehörigen zweiten Datenweiche (DW2) verbunden ist, daß bei jeder der vierten Datenweichen (DW4) der andere Transistor mit seinem Sourceanschluß mit dem Ausgang der zugehörigen Auswerteschaltung (AS) verbunden ist, daß das Gate des einen Transistors mit einem zum Steuersignal (P) komplementären Signal ($\overline{P}$) verbunden ist, und daß das Gate des anderen Transistors mit dem Steuersignal (P) verbunden ist.

8. Integrierter Halbleiterspeicher nach einem der vorhergehenden Ansprüche, **dadurch gekennzeichnet,** daß der weitere Anschluß für das Steuersignal (P) ein eigener, sonst unbenutzter Anschluß (TA) des Halbleiterspeichers ist.

9. Integrierter Halbleiterspeicher nach einem der vorhergehenden Ansprüche, **dadurch gekennzeichnet,** daß der weitere Anschluß für das Steuersignal (P) ein Anschluß ($A_x$) ist, der auch für sonstige Signale vom Halbleiterspeicher benutzt wird.

10. Integrierter Halbleiterspeicher nach Anspruch 9, **dadurch gekennzeichnet,** daß der weitere Anschluß ($A_x$) ein Anschluß ist, an den bei einem Normalbetrieb ein Adreßsignal (A) angelegt wird, das das höchstwertige der Adreßsignale ist.

11. Integrierter Halbleiterspeicher nach Anspruch 9 oder 10, **dadurch gekennzeichnet,** daß zum Umschalten vom Normalbetrieb auf einen Testbetrieb, bei dem die Auswerteschaltungen (AS) benützt werden, ein größeres Potential angelegt wird, als das, das dem Anlegen einer log. "1" entspricht.

12. Integrierter Halbleiterspeicher nach Anspruch 11, **dadurch gekennzeichnet,** daß das Steuersignal (P) mittels einer Diskriminatorschaltung (DS) aktiviert wird, die erkennt, ob das größere Potential anliegt.

13. Integrierter Halbleiterspeicher nach einem der vorhergehenden Ansprüche, **dadurch gekennzeichnet,** daß der Ausgang jeder der m zweiten Datenweichen (DW2) direkt auf den jeweils zugehörigen Datenausgangsanschluß ($D_o$) geführt ist, während der Ausgang jeder der zugehörigen m Auswerteschaltungen (AS) auf einen eigenen, sonst unbenutzten Anschluß (PA) geführt ist.

## Claims

1. Integrated semiconductor memory having the following features:
   - n identical memory cell fields (ZF),
   - n • m data lines (DL) for writing memory data into and reading memory data out of the memory cell fields (ZF),
   - m first data switches (DW1), each of which applies memory data which are present during writing at a data input terminal ($D_i$) assigned to it and are to be written into the semiconductor memory to in each case one of the n associated data lines (DL) depending on addressing data,
   - m second data switches (DW2), each of which selects one of the n data lines (DL), depending on addressing data, during reading out of memory data which are present on in each case n data lines (DL), and applies them via an output to an associated data output terminal ($D_o$),
   - connected to in each case n of the n • m data lines (DL), parallel to the respective second data switch (DW2), is an evaluation circuit (AS) having an output signal ($AUS_{Test}$), which contains either the memory data read out of the memory cell fields (ZF) or, in the case where at least one and at most n-1 memory data are defective, has a high-resistance state,
   - connected between each of the m data input terminals ($D_i$) and the associated n of n • m data lines (DL), parallel to the respective first data switch (DW1), is a third data switch (DW3) which, depending on a control signal (P), transfers the memory data to be written into the semiconductor memory in parallel to all of the n data lines (DL),
   - preceding each of the m data output terminals ($D_o$) is a fourth data switch (DW4) which, depending on the control signal (P) and its complementary signal ($\overline{P}$), either connects through the memory data ($AUS_{Norm}$) selected by the second data switch (DW2) or the output signal ($AUS_{Test}$) generated by the evaluation circuit (AS) to the data output terminal ($D_o$), the data output terminal ($D_o$) also having a high-resistance state in the case where the output signal ($AUS_{Test}$) generated by the evaluation circuit (AS) has the high-resistance state,
   - a further terminal ($A_x$; TA) is provided for the control signal (P),
   - for switching through the memory data read out of the memory cell fields (ZF), each evaluation circuit (AS) contains a first multivibrator circuit (FF1) having two inputs and one output, the first input of which, referred to as the set input (S), is activated when all n data lines (DL) connected to the evaluation circuit (AS) have a first logical state in the O.K. case, and the second input of which, referred to as the reset input (R), is activated when all n data lines (DL) connected to the evaluation circuit (AS) have in the O.K. case a second logical state complementary to the first logical state, so that in the case where all aforesaid n data lines (DL) have the same first or second logical states, the output of the first multivibrator circuit (FF1) is set or reset selectively,
   - in the fault case, where all n data lines (DL) connected to the evaluation circuit (AS) neither have the first nor the second logical state, a second multivibrator circuit (FF2) is provided with two inputs and one output, the first input of which, referred to as the reset input (R), resets the output of the second multivibrator circuit (FF2) in the event of a fault, and the other input of which, referred to as the set input (S), is addressed for setting the output of the second multivibrator circuit (FF2) via the output of a set circuit (SS).

2. Integrated semiconductor memory according to Claim 1, characterised in that the output of the set circuit (SS) is activated on the one hand upon activation of the control signal (P) or upon application of an operating voltage to the semiconductor memory by a differentiation stage (DG), and on the other hand by means of a machine clock (CLK).

3. Integrated semiconductor memory according to Claim 1 or 2, characterised in that, by means of the set input (S) of the second multivibrator circuit (FF2), the output thereof is set at the beginning of each clock period (TP).

4. Integrated semiconductor memory according to one of Claims 1 to 3, characterised in that the output signal ($AUS_{Test}$) of each evaluation circuit (AS) is generated by means of a transistor (T), the source of which is connected to the output of the first multivibrator circuit (FF1), the drain of which carries the output signal

($AUS_{Test}$), and the gate of which is connected to the output of the second multivibrator circuit (FF2).

5. Integrated semiconductor memory having the following features:
   - n identical memory cell fields (ZF),
   - n • m data lines (DL) for writing memory data into and reading memory data out of the memory cell fields (ZF),
   - m first data switches (DW1), each of which applies memory data which are present during writing at a data input terminal ($D_i$) assigned to it and are to be written into the semiconductor memory to in each case one of the n associated data lines (DL) depending on addressing data,
   - m second data switches (DW2), each of which selects one of the n data lines (DL), depending on addressing data, during reading out of memory data which are present on in each case n data lines (DL), and applies them via an output to an associated data output terminal ($D_o$),
   - connected to in each case n of the n • m data lines (DL), parallel to the respective second data switch (DW2), is an evaluation circuit (AS) having an output signal ($AUS_{Test}$), which contains either the memory data read out of the memory cell fields (ZF) or, in the case where at least one and at most n-1 memory data are defective, has a high-resistance state,
   - connected between each of the m data input terminals ($D_i$) and the associated n of n • m data lines (DL), parallel to the respective first data switch (DW1), is a third data switch (DW3) which, depending on a control signal (P), transfers the memory data to be written into the semiconductor memory in parallel to all of the n data lines (DL),
   - preceding each of the m data output terminals ($D_o$) is a fourth data switch (DW4) which, depending on the control signal (P) and its complementary signal ($\overline{P}$), either connects through the memory data ($AUS_{Norm}$) selected by the second data switch (DW2) or the output signal ($AUS_{Test}$) generated by the evaluation circuit (AS) to the data output terminal ($D_o$), the data output terminal ($D_o$) also having a high-resistance state in the case where the output signal ($AUS_{Test}$) generated by the evaluation circuit (AS) has the high-resistance state,
   - a further terminal ($A_x$; TA) is provided for the control signal (P),
   - the evaluation circuit (AS) has two AND gates (G1, G2) having in each case n inputs and one output,
   - the inputs of the second AND gate (G2) are inverted,
   - the output of the first AND gate (G1) is connected to the source of a transistor (T), at the drain of which the output signal ($AUS_{Test}$) of the evaluation circuit (AS) is produced,
   - the gate of the transistor (T) is connected to the output of an OR gate (OG) having two inputs,
   - the one input of the OR gate (OG) is connected to the output of the first AND gate (G1) and the second input of the OR gate (OG) is connected to the output of the second AND gate (G2).

6. Integrated semiconductor memory according to one of the preceding claims, characterised in that each of the third data switches (DW3) contains n transistors, which are all connected by means of their conduction paths on the one hand to the associated data input terminal ($D_i$) and on the other hand to in each case one of the n data lines (DL) belonging to the respective data input terminal ($D_i$), and the gates of which are connected parallel to the control signal (P).

7. Integrated semiconductor memory according to one of the preceding claims, characterised in that each of the m fourth data switches (DW4) contains two transistors, in that the drain terminals of the two transistors are connected together and to the data output terminal ($D_o$) associated with the respective fourth data switch (DW4), in that, in each of the fourth data switches (DW4), the one transistor is connected by means of its source terminal to the output of the associated second data switch (DW2), in that, in each of the fourth data switches (DW4), the other transistor is connected by means of its source terminal to the output of the associated evaluation circuit (AS), in that the gate of the one transistor is connected to a signal ($\overline{P}$) complementary to the control signal (P), and in that the gate of the other transistor is connected to the control signal (P).

8. Integrated semiconductor memory according to one of the preceding claims, characterised in that the further terminal for the control signal (P) is a separate, otherwise unused terminal (TA) of the semiconductor memory.

9. Integrated semiconductor memory according to one of the preceding claims, characterised in that the further terminal for the control signal (P) is a terminal ($A_x$) which is also used by the semiconductor memory for other signals.

10. Integrated semiconductor memory according to Claim 9, characterised in that the further terminal ($A_x$) is a terminal at which, during normal operation, an address signal (A) which is the most significant of the address signals is applied.

11. Integrated semiconductor memory according to Claim 9 or 10, characterised in that, for switching from normal operation to test operation in which the evaluation circuits (AS) are used, a higher potential than that corresponding to the application of a log. "1" is applied.

12. Integrated semiconductor memory according to Claim 11, characterised in that the control signal (P) is activated by means of a discriminator circuit (DS) which detects whether the higher potential is applied.

13. Integrated semiconductor memory according to one of the preceding claims, characterised in that the output of each of the m second data switches (DW2) is connected directly to the respective associated data output terminal ($D_o$), while the output of each of the associated m evaluation circuits (AS) is connected to a separate, otherwise unused terminal (PA)

## Revendications

1. Mémoire intégrée à semiconducteurs, présentant les caractéristiques suivantes:
   - n zones identiques (ZF) de cellules de mémoire,
   - n.m conducteurs de transmission de données (DL) pour enregistrer et lire des données dans ou à partir des zones (ZF) des cellules de mémoire,
   - m premiers aiguillages de transmission de données (DW1), dont chacun applique, lors de l'enregistrement, des données de mémoire appliquées à une borne ($D_i$) d'entrée de données, qui lui est associée, et devant être enregistrées dans la mémoire à semiconducteurs, en fonction de données d'adressage, respectivement à l'un des n conducteurs de transmission de données (DL), qui lui sont associés,
   - m seconds aiguillages de transmission de données (W2), dont chacun sélectionne, lors de la lecture de données de mémoire, qui sont présentes dans n conducteurs respectifs de transmission de données (DL), en fonction de données d'adressage, l'un des n conducteurs de transmission de données (DL) et le raccorde au moyen d'une sortie à une borne associée ($D_o$) de sortie de données,
   - à respectivement n des n.m conducteurs de transmission de données (DL) est raccordé, en parallèle avec le second aiguillage respectif de transmission de données (DW2), un circuit d'évaluation (AS), qui délivre un signal de sortie ($AUS_{Test}$), qui soit contient les données de mémoire lues à partir des zones (ZF) des cellules de mémoire, soit possède un état de forte valeur ohmique, dans le cas de l'apparition d'au moins une et au maximum de n-1 données défectueuses de mémoire,
   - entre chacune des m bornes ($D_i$) d'entrée de données et les n conducteurs associés faisant partie de n.m conducteurs de transmission de données (DL) est branchée, parallèlement au premier aiguillage respectif de transmission de données (DW1), un troisième aiguillage de transmission de données (DW3), qui, en fonction d'un signal de commande (P), transfère en parallèle les données de mémoire devant être enregistrées dans la mémoire à semiconducteurs, à l'ensemble des n conducteurs de transmission de données (DL),
   - en amont de chacune des m bornes ($D_o$) de sortie des données est raccordé un quatrième aiguillage de transmission de données (DW4), qui, en fonction du signal de commande (P) et d'un signal ($\overline{P}$) complémentaire du précédent, soit transfère directement la donnée de mémoire ($AUS_{Norm}$) sélectionnée par le second aiguillage de transmission de données (DW2), soit le signal de sortie ($AUS_{Test}$) produit par le circuit d'évaluation (AS), à la borne ($D_o$) de sortie des données, auquel cas, lorsque le signal de sortie ($AUS_{Test}$) produit par le circuit d'évaluation (AS) possède un état de forte valeur ohmique, la borne ($D_o$) de sortie des données possède également un état de forte valeur ohmique,
   - pour le signal de commande (P), il est prévu une autre borne ($A_x$;TA),
   - chaque circuit d'évaluation (AS) comporte, pour le transfert direct des données de mémoire lues à partir des zones (ZF) des cellules de mémoire, un premier circuit à bascule (FF1) comportant deux entrées et une sortie, dont la première entrée, dite entrée de positionnement (S), est activée lorsque la totalité des n conducteurs de transmission de données (DL) raccordés au circuit d'évaluation (AS) possèdent, dans un cas valable, un premier état logique, et dont la seconde entrée, dite entrée de remise à l'état initial (R), est activée lorsque l'ensemble des n conducteurs de transmission de données (DL), raccordés au circuit d'évaluation (AS), possèdent, dans le cas valable, un second état logique complémentaire du premier état logique, de sorte que dans le cas où la totalité desdits n conducteurs de transmission de données (DL) possèdent le même premier ou second état logique, et que la sortie du premier circuit à bascule (FF1) est positionnée ou ramenée à l'état initial, d'une manière ciblée,
- dans le cas d'erreurs, où la totalité des n conducteurs de transmission de données (DL), raccordés au circuit d'évaluation (AS), possèdent en commun soit le premier état logique, soit le second état logique, il est prévu un second circuit à bascule (FF2) comportant deux entrées et une sortie, dont une entrée, dite entrée de remise à l'état initial (R), ramène à l'état initial, dans le cas d'une erreur, la sortie du second circuit à bascule (FF2) et dont l'autre entrée, dite entrée de positionnement (S), est commandée de manière à positionner la sortie du second circuit à bascule (FF2) par l'intermédiaire de la sortie d'un circuit de positionnement (SS).

2. Mémoire intégrée à semiconducteurs suivant la revendication 1, caractérisée par le fait que la sortie du circuit de positionnement (SS) est activée, d'une part, lors d'une activation du signal de commande (P) ou lors de l'application d'une tension de service à la mémoire à semiconducteurs au moyen d'un circuit différentiateur (DG), et, d'autre part, au moyen d'une cadence machine (CLK).

3. Mémoire intégrée à semiconducteurs suivant la revendication 1 ou 2, caractérisée par le fait que la sortie du second circuit à bascule (FF2) est positionnée au moyen de l'entrée de positionnement (S) de ce circuit, au début de chaque période de cadence (TP).

4. Mémoire intégrée à semiconducteurs suivant l'une des revendications 1 à 3, caractérisée par le fait que le signal de sortie ($AUS_{Test}$) de chaque circuit d'évaluation (AS) est produit au moyen d'un transistor (T), dont la source est raccordée à la sortie du premier circuit à bascule (FF1), dont le drain délivre le signal de sortie ($AUS_{Test}$) et dont la grille est raccordée à la sortie du second circuit à bascule (FF2).

5. Mémoire intégrée à semiconducteurs présentant les caractéristiques suivantes :
   - n zones identiques (ZF) de cellules de mémoire,
   - n.m conducteurs de transmission de données (DL) pour enregistrer et lire des données dans ou à partir des zones (ZF) des cellules de mémoire,
   - m premiers aiguillages de transmission de données (DW1), dont chacun applique, lors de l'enregistrement, des données de mémoire appliquées à une borne ($D_i$) d'entrée de données, qui lui est associée, et devant être enregistrées dans la mémoire à semiconducteurs, en fonction de données d'adressage, respectivement à l'un des n conducteurs de transmission de données (DL) qui lui sont associés,
   - m seconds aiguillages de transmission de données (W2), dont chacun sélectionne, lors de la lecture de données de mémoire, qui sont présentes dans n conducteurs respectifs de transmission de données (DL), en fonction de données d'adressage, l'un des n conducteurs de transmission de données (DL) et le raccorde au moyen d'une sortie à une borne associée ($D_o$) de sortie de données,
   - à respectivement n des n.m conducteurs de transmission de données (DL) est raccordé, en parallèle avec le second aiguillage respectif de transmission de données (DW2), un circuit d'évaluation (AS) qui délivre un signal de sortie ($AUS_{Test}$), qui soit contient les données de mémoire lues à partir des zones (ZF) des cellules de mémoire, soit possède un état de forte valeur ohmique, dans le cas de l'apparition d'au moins une et au maximum de n-1 données défectueuses de mémoire,
   - entre chacune des m bornes ($D_i$) d'entrée de données et les n conducteurs associés faisant partie de n.m conducteurs de transmission de données (DL) est branchée, parallèlement au premier aiguillage respectif de transmission de données (DW1), un troisième aiguillage de transmission de données (DW3), qui, en fonction d'un signal de commande (P), transfère en parallèle les données de mémoire devant être enregistrées dans la mémoire à semiconducteurs, à l'ensemble des n conducteurs de transmission de données (DL),

- en amont de chacune des m bornes ($D_o$) de sortie des données est raccordé un quatrième aiguillage de transmission de données (DW4), qui, en fonction du signal de commande (P) et d'un signal ($\overline{P}$) complémentaire du précédent, soit transfère directement la donnée de mémoire ($AUS_{Norm}$) sélectionnée par le second aiguillage de transmission de données (DW2), soit le signal de sortie ($AUS_{Test}$) produit par le circuit d'évaluation (AS), à la borne ($D_o$) de sortie des données, auquel cas, lorsque le signal de sortie ($AUS_{Test}$) produit par le circuit d'évaluation (AS) possède un état de forte valeur ohmique, la borne ($D_o$) de sortie des données possède également un état de forte valeur ohmique,
- pour le signal de commande (P), il est prévu une autre borne ($A_x$;TA),
- le circuit d'évaluation (AS) comporte deux portes ET (G1, G2) comportant chacune n entrées et une sortie,
- les entrées de la seconde porte ET (G2) sont inversées,
- la sortie de la première porte ET (G1) est raccordée à la source d'un transistor (T), sur le drain duquel apparaît le signal de sortie ($AUS_{test}$) du circuit d'évaluation (AS),
- la grille du transistor (T) est raccordée à la sortie d'une porte OU (OG) comportant deux entrées,
- une entrée de la porte OU (OG) est raccordée à la sortie de la première porte ET (G1), et la seconde entrée de la porte OU (OG) est raccordée à la sortie de la seconde porte ET (G2).

6.  Mémoire intégrée à semiconducteurs suivant l'une des revendications précédentes, caractérisée par le fait que chacun des troisièmes aiguillages de transmission de données (DW3) comporte n transistors, dont les sections passantes sont raccordées d'une part toute à la borne associée d'entrée de données ($D_i$) et d'autre part à l'un respectif des n conducteurs de transmission de données (DL) associés à la borne respective d'entrée de données ($D_i$), et aux grilles desquels est appliqué en parallèle le signal de commande (P).

7.  Mémoire intégrée à semiconducteurs suivant l'une des revendications précédentes, caractérisée par le fait que chacun des m quatrièmes aiguillages de transmission de données (DW4) comporte deux transistors, que les bornes de drain de ces deux transistors sont interconnectés et raccordés à la borne de sortie de données ($D_o$) associée au quatrième aiguillage respectif de transmission de données (DW4), que dans chacun des quatre aiguillages de transmission de données (DW4), un transistor est raccordé par sa borne de source à la sortie du second aiguillage associé de transmission de données (DW2), que pour chacun des quatre aiguillages de transmission de données (DW4), l'autre transistor est raccordé par sa borne de source à la sortie du circuit associé d'évaluation (AS), que la grille d'un transistor reçoit un signal ($\overline{P}$) complémentaire du signal de commande (P) et que la grille de l'autre transistor reçoit le signal de commande (P).

8.  Mémoire intégrée à semiconducteurs suivant l'une des revendications précédentes, caractérisée par le fait que l'autre borne pour le signal de commande (P) est une borne particulière (TA), par ailleurs non utilisée, de la mémoire à semiconducteurs.

9.  Mémoire intégrée à semiconducteurs suivant l'une des revendications précédentes, caractérisée par le fait que l'autre borne pour le signal de commande (P) est une borne ($A_x$), qui est également utilisée pour d'autres signaux provenant de la mémoire à semiconducteurs.

10. Mémoire intégrée à semiconducteurs suivant la revendication 9, caractérisée par le fait que l'autre borne ($A_x$) est une borne à laquelle est appliqué, pendant un fonctionnement normal, un signal d'adresse (A) qui possède la valeur maximale des signaux d'adresses.

11. Mémoire intégrée à semiconducteurs suivant la revendication 9 ou 10, caractérisée par le fait que pour le passage du fonctionnement normal à un fonctionnement de test, lors duquel on utilise les circuits d'évaluation (AS), on applique un potentiel supérieur à celui qui correspond à l'application d'un "1" logique.

12. Mémoire à semiconducteurs suivant la revendication 11, caractérisée par le fait que le signal de commande (P) est activé au moyen d'un circuit discriminateur (DS) qui identifie si le potentiel supérieur est appliqué.

**13.** Mémoire à semiconducteurs suivant l'une des revendications précédentes, caractérisé par le fait que la sortie de chacun des m seconds aiguillages de transmission de données (DW2) est raccordé directement à la borne respectivement associée ($D_o$) de sortie des données, tandis que la sortie de chacun m circuits associés d'évaluation (AS) est raccordée à une borne particulière (PA), par ailleurs non utilisée.

# FIG 1

# FIG 2

# FIG 3

# FIG 4

# FIG 5

FIG 6

EP 0 214 508 B1

# FIG 7

# FIG 8